(19) Europäisches Patentamt

European Patent Office

Office européen des brevets

(11) **EP 1 376 092 A2**

(12) **EUROPEAN PATENT APPLICATION**

(43) Date of publication:
02.01.2004 Bulletin 2004/01

(51) Int Cl.⁷: **G01M 11/00**, G03F 7/20

(21) Application number: 03013977.8

(22) Date of filing: 20.06.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: 21.06.2002 US 390661 P
11.03.2003 US 387161

(71) Applicant: **Nikon Corporation**
**Chiyoda-ku, Tokyo 100-1005 (JP)**

(72) Inventor: **Sogard, Michael R., c/o Nikon Corporation**
**Chiyoda-ku, Tokyo 100-1005 (JP)**

(74) Representative: **Viering, Jentschura & Partner Patent- und Rechtsanwälte,**
**Steinsdorfstr. 6**
**80538 München (DE)**

(54) **Method and device for controlling thermal distortion in elements of a lithography system**

(57)     An element control system (32) that reduces the effects on image quality of thermal distortions in an optical element (28) of a lithography system (10) includes a heat source (50) that primarily heats a non-illuminated region (44) of the optical element (28) to alter and/or control the shape of the illuminated part of the optical element (28). The heat source (50) directs heat to the non-illuminated region (44) and/or an illuminated region (42) to simplify and/or alter the shape of thermal distortions aberrations in the optical element (28).

Figure 1

EP 1 376 092 A2

## Description

### RELATED APPLICATION

This application is a continuation of Provisional Application Serial No. 60/390,661 filed on June 21, 2002, entitled "METHOD AND DEVICE FOR CONTROLLING THERMAL DISTORTION IN ELEMENTS OF A LITHOGRAPHY STSTEM" which is currently pending. As far as is permitted, the contents of provisional Application Serial No. 60/390,661 is incorporated herein by reference.

### BACKGROUND

Lithography systems are commonly used to transfer images from a reticle onto a semiconductor wafer during semiconductor processing. A typical lithography system includes an illumination source, a reticle stage assembly that positions a reticle, an optical assembly and a wafer stage assembly that positions a semiconductor wafer.

The size of the features within the images transferred from the reticle onto the wafer is extremely small. In order to increase the resolution of the features and decrease the size of the features within the images, there is a need to use an illumination source that generates smaller or shorter wavelengths of light to transfer the images from the reticle onto the wafer. For example, extreme ultraviolet (EUV) radiation, including wavelengths in the 11 to 13 nm range, is being evaluated for use in lithography systems.

For extreme ultraviolet lithography systems, the optical assembly typically includes one or more reflective, optical elements, e.g. mirrors. Each optical element can include multiple layers of two different indices to reflect the extreme ultraviolet radiation. With the layers, these optical elements have a reflectivity of no greater than approximately 0.65. As a result thereof, a portion of the extreme ultraviolet radiation is absorbed by the optical element. The absorbed ultraviolet radiation heats the illuminated regions of the optical element and causes the temperature in the illuminated regions to rise to a greater extent than the temperature in non-illuminated regions of the optical element.

Unfortunately, the increase in temperature in the illuminated regions causes the optical element, including the figure of the optical element, to distort. For extreme ultraviolet radiation lithography, distortions of the figure that are as small as approximately 1 nm RMS can cause image degrading optical aberrations. For example, this can blur the image that is transferred onto the wafer.

Further, in order to achieve relatively high throughputs for the lithography system, the illumination source will be required to generate significant levels of power. This can lead to significant heating of the optical elements and thus significant optical aberrations in the optical elements.

One attempt to reduce thermally induced optical aberrations in an optical element includes directing a cooling fluid through one or more fluid channels in the optical element. However, even with cooling, thermal stresses in the optical element may still cause significant thermal deformation. Therefore, some residual surface deformation may remain from thermal stresses, even with active cooling. In addition, there may be a practical limitation on active cooling performance, because vibrations of the optical element from the cooling fluid must be severely constrained to maintain the optical figure and alignment tolerances.

Another attempt to reduce optical aberrations includes pre-distorting the optical element with one or more of the optical mounts that retain the optical element. In this embodiment, the optical mounts pre-distort the optical element to approximately cancel out the thermal distortion produced by the illumination beam. However, pre-distorting with the optical mounts may only be successful in correcting relatively simple form distortions. For example, pre-distorting the optical element is not expected to be very successful when the heat load is restricted to a small asymmetric location on the optical element, and/or if the heat load varies with time.

In light of the above, there is a need for device and method for reducing and controlling thermal distortion, and reducing optical aberrations in optical elements. Additionally, there is a need for a device and method for providing a controlled and constant temperature distribution in optical elements. Moreover, there is a need for a lithography system capable of manufacturing precision devices such as high density, semiconductor wafers.

### SUMMARY

The present invention is directed to an optical element control system that reduces thermal distortions in an optical element. The optical element includes an illuminated region and a non-illuminated region. The element control system includes a heat source that primarily heats at least a portion of the non-illuminated region of the optical element. As provided herein, the heat source can direct heat to substantially the entire non-illuminated region of the optical element or at least a portion of the non-illuminated region. The heat is absorbed by the optical element thereby heating the element. In one embodiment, the heat source is a beam of electromagnetic radiation. Alternatively, in another embodiment, the heat source can be a heated surface in proximity to the non-illuminated region, with the heating of the non-illuminated region produced by radiant heat transfer. In one embodiment, the element control system alters the shape of the thermal distortions.

With this design radiation from the heat source heats a portion of the optical element to control the shape of the optical element, and/or provide a controlled and uniform temperature distribution in a region of the optical element. Stated another way, the heat source transfers radiation to selective regions of the optical element to alter the shape of the optical element. In alternative embodiments, the amount of radiation from the heat source collected by the non-illuminated region is at least approximately 10%, 20%, 30%, 40%, 50%, 60%, 70%, 80%, 90% or 100% greater than the amount of radiation collected by the illuminated region. This should simplify and stabilize thermal distortions, and reduce some optical aberrations in the optical element.

The distortion arises from the physical expansion most materials experience when their temperature is increased. The expansion causes the surface of the optical element to be displaced. However, if the temperature rise of the optical element is substantially uniform, the resulting displacement of the surface may be of a relatively simple form, and simple mechanical realignment of the optical element may eliminate the effects of the heating on the optical aberrations. For example, if thermal expansion causes the surface to be displaced uniformly along the optical axis, it can be compensated by a simple adjustment of the position of the optical element, so that the surface is returned to its original position. If the expansion causes a surface of spherical shape to change its radius of curvature slightly, again a simple position adjustment along the optical axis may eliminate the effects of expansion. If the expansion causes the surface to be uniformly tilted relative to the optical axis, it can again be corrected for by a simple compensating tilt to the optical element. The advantage of correcting the thermal distortion to a relatively simple form is maintained, even if the total distortion is actually increased in magnitude by the additional sources of heat.

Aberrations more complicated than those discussed above are here described as higher order. Higher order aberrations include, for example, more complicated shapes such as astigmatism, spherical aberrations, coma, and sealed curvature to all orders. When the higher order aberrations are reduced by the present invention, the aberrations are here described as being simplified.

In certain situations, the temperature distribution of the heated optical element cannot be controlled to be completely uniform. For example, the temperature at and/or near the surface of the optical element is uniform over the illuminated region, but the temperature varies through the thickness of the optical element, much of the above argument still holds. The effect of a temperature gradient through the thickness of the optical element contributes a thermal distortion that is mainly non-local in effect, leading to relatively simple changes in the shape of the surface of the optical element. Such changes may be correctable by the means described above. Thus, higher order aberrations may still be reduced or avoided.

Further, if the temperature distribution in the heated optical element is non-uniform near its surface and in the region including and adjacent to the illuminated region, local deformation of the surface within the illuminated region will in general occur, and the aberrations associated with this distortion are unlikely to be compensated by mechanical adjustment of the optical element. The heat source provided herein can be used to simplify these types of aberrations.

In one embodiment, the shape and/or intensity of the heating radiation from the heat source is controlled so that a temperature of a portion of the non-illuminated region is substantially equal to a temperature of the illuminated region. Moreover, the shape and/or intensity of the heating radiation from the heat source can be varied with time.

In one embodiment, the heating radiation is a beam of light having a wavelength, or wavelengths, that does not influence a photoresist on a wafer. With this design, stray light from the heat source that reaches the wafer will not influence the photoresist on the wafer. However, in one embodiment, stray radiation is limited in order not to heat the wafer and its photoresist appreciably, or other critical Parts of the lithography system.

Additionally, the element control system can include an element measurement system that monitors at least a portion of the optical element for thermal distortions. With this design, the shape and/or intensity of the heating radiation from the heat source can be varied according to the measurements take by the element measurement system.

In another embodiment, a portion of the non-illuminated region of the optical element includes an absorbing layer that enhances the absorption of energy from the heat source.

The present invention is also directed to an optical assembly, an exposure apparatus, a device made with the exposure apparatus, a wafer made with the exposure apparatus, a method for controlling thermal distortion of an optical element, a method for making an exposure apparatus, a method for making a device and a method for manufacturing a wafer.

## BRIEF DESCRIPTION OF THE DRAWINGS

The novel features of this invention, as well as the invention itself, both as to its structure and its operation, will be best understood from the accompanying drawings, taken in conjunction with the accompanying description, in which similar reference characters refer to similar parts, and in which:

Figure 1 is a schematic view of a lithography system having features of the present invention;
Figure 2A is a front plan view of an optical element illustrating an illuminated region and a non-illuminated region;
Figure 2B is a front plan view of an optical element illustrating the illuminated region, the non-illuminated region, and a heated region;

Figure 2C is a plot of the temperature distribution along the azimuthal direction in and near the illuminated region for several embodiments of the non-illuminated region;

Figure 3A is a side illustration of another optical element, and a portion of an element control system having features of the present invention;

Figure 3B is a front plan view of the optical element of Figure 3A illustrating the illuminated region, the non-illuminated region, and the heated region;

Figure 4A is a front plan view of another optical element, illustrating the illuminated region, the non-illuminated region, and the heated region;

Figure 4B is a plot of the temperature distribution along the radial direction in and near the illuminated region for several embodiments of the non-illuminated region;

Figure 4C is a front plan view of yet another optical element illustrating the illuminated region, the non-illuminated region, and the heated region;

Figure 5A is a aide illustration of another optical element and a portion of an element control system having features of the present invention;

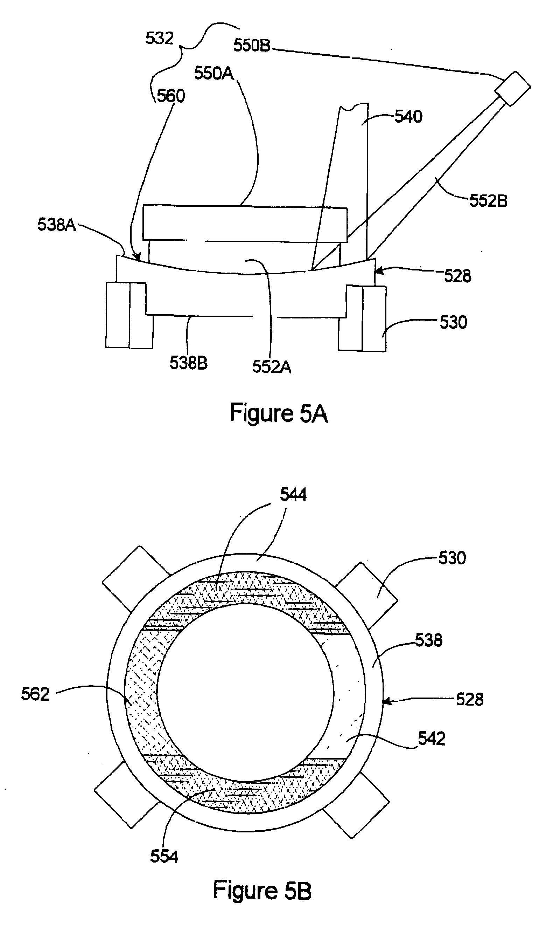

Figure SB is a front plan view of the optical element of Figure 5A illustrating the illuminated region, the non-illuminated region, and the heated region;

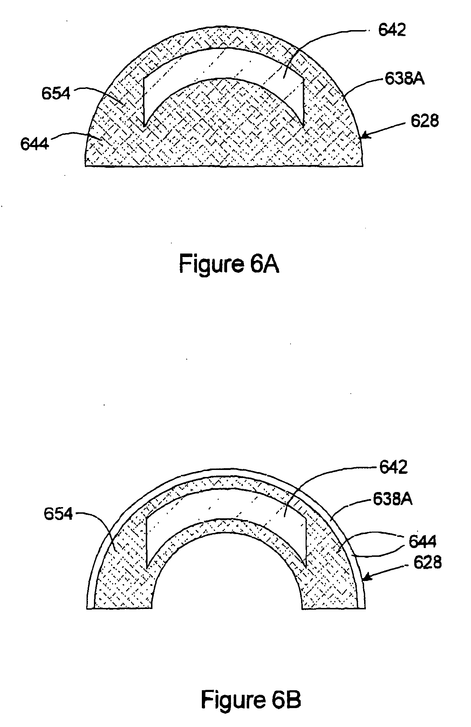

Figures 6A and 6B illustrate alternate embodiments of optical elements, including the illuminated region, the non-illuminated region, and the heated region; and

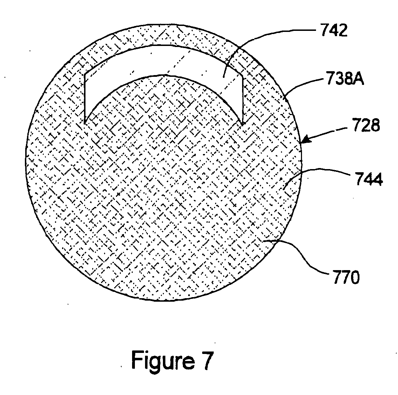

Figure 7 is a front plan view of an optical element illustrating the illuminated region, the non-illuminated region, and an absorbing layer.

## DESCRIPTION

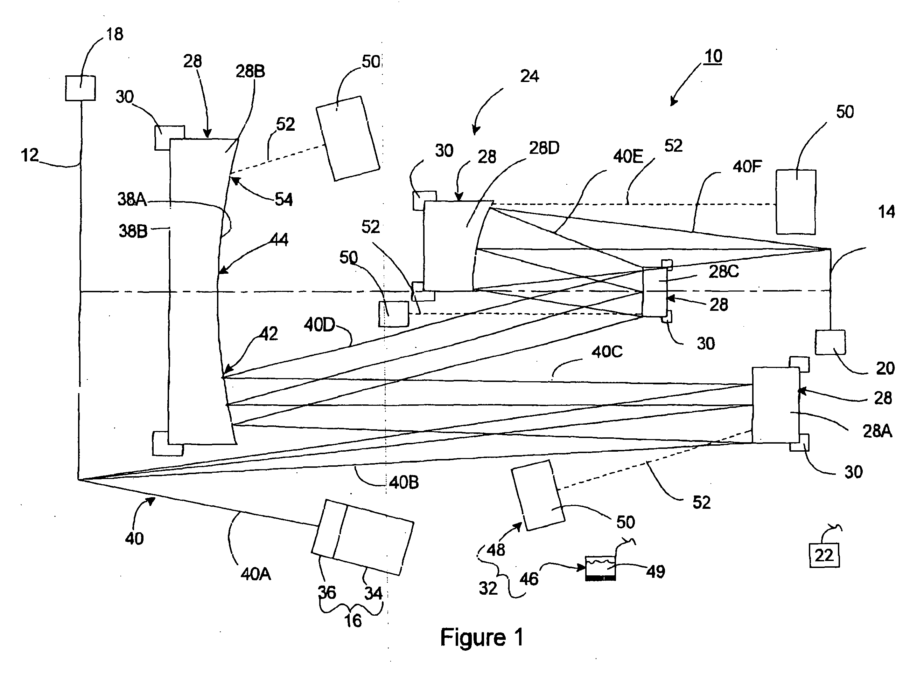

Figure 1 is a schematic view that illustrates a precision assembly, namely a lithography system 10. The lithography system 10 can be used to transfer a pattern (not shown) of an integrated circuit from a reticle 12 onto a device, such as a semiconductor wafer 14. In Figure 1, the lithography system 10 includes an illumination system 16 (irradiation apparatus), a reticle stage assembly 18 (illustrated as a box), a wafer stage assembly 20 (illustrated as a box), a control system 22 (illustrated as a box), and an optical assembly 24. The design of the components of the lithography system 10 including the components of the optical assembly 24 can be varied to suit the design requirements of the lithography system 10.

The optical assembly 24 includes one or more optical elements 28, one or more element mounts 30, and an element control system 32. As an overview, the element control system 32 reduces thermal distortions and/or optical aberrations in one or more of the optical elements 28. For example, the element control system 32 can provide a controlled and constant temperature distribution in a region of one or more of the optical elements 28. This reduces and stabilizes thermal distortions and reduces optical aberrations. As a result thereof, the lithography system 10 is capable of manufacturing precision devices such as high density, semiconductor wafers. Moreover, this can also simplify additional mechanical adjustments to the surface of the one or more optical elements 28.

There are a number of different types of lithographic systems 10. For example, the lithography system 10 can be used as a scanning type photolithography system that transfers the pattern from the reticle 12 onto the wafer 14 with the reticle 12 and the wafer 14 moving synchronously. In a scanning type lithographic device, the reticle 12 is moved perpendicular to an optical axis of the optical assembly 24 by the reticle stage assembly 18 and the wafer 14 is moved perpendicular to an optical axis of the optical assembly 24 by the wafer stage assembly 20. Scanning of the reticle 12 and the wafer 14 occurs while the reticle 12 and the wafer 14 are moving synchronously.

Alternatively, the lithography system 10 can be a step-and-repeat type photolithography system that exposes the reticle 12 while the reticle 12 and the wafer 14 are stationary. In the step and repeat process, the wafer 14 is in a constant position relative to the reticle 12 and the optical assembly 24 during the exposure of an individual field. Subsequently, between consecutive exposure steps, the wafer 14 is consecutively moved with the wafer stage assembly 20 perpendicular to the optical axis of the optical assembly 24 so that the next field of the wafer 14 is brought into position relative to the optical assembly 24 and the reticle 12 for exposure. Following this process, the images on the reticle 12 are sequentially exposed onto the fields of the wafer 14 so that the next field of the wafer 14 is brought into position relative to the optical assembly 24 and the reticle 12.

The reticle 12 can be a reflective type as illustrated in Figure 1 or a transmissive type. However, in the following description the reticle 12 is reflective. The pattern in the reticle that is to be transferred to the wafer is defined by the local regions of the reticle where the reflectivity at the illumination radiation wavelengths of the reticle surface has been reduced to a very small value, thereby providing maximum image contrast at the wafer. The wafer 14 includes a substrate that is covered with a photoresist. The photoresist can be photosensitive to some wavelengths of radiation and not sensitive to other wavelengths of radiation. For example, the photoresist can be sensitive to extreme electromagnetic ultraviolet radiation including wavelengths in the 10 to 15 nm range and not sensitive to radiation having wavelengths that are greater than approximately 50 nm, 75 nm, 100 nm, 125 nm, 150 nm, 175 nm, 200 nm, 250 nm, 300 nm, 350 nm, 400 nm, 450 nm or 500 nm.

The illumination system 16 includes an illumination source 34 and an illumination optical assembly 36. The illumination source 34 and the illumination optical assembly 36 create and guide the illumination beam 40 from the illumination source 34 to the reticle 12. The illumination beam 40 selectively illuminates a portion of the reticle 12. Radiation reflected from the reticle is collected by the optical assembly 24 and focused on the semiconductor wafer 14 to expose the photosensitive resist. The fraction of radiation reflected depends on both the intrinsic reflectivity of the reticle surface and the fraction of the surface occupied by the pattern.

In one embodiment, the illumination source 34 generates an illumination beam 40 that provides extreme ultraviolet (EUV) electromagnetic radiation, including illumination wavelengths of between approximately 10-15 nm and typically illumination wavelengths in the 11 to 13 nm range, also referred to as the soft X-ray region. In this design, the illumination source 34 can be a synchrotron radiation source or laser plasma source. Alternatively, for example, the illumination source 34 can be a gas discharge source.

In one embodiment, the illumination source 34 is pulsed in time, with repetition rates of between approximately 0.1-10 kHz. Alternatively, in another embodiment, the illumination source 34 is continuous. Additionally, the total radiation from the illumination source 34 incident on the optical elements 28 will vary with the average reflectance of the illuminated region of the reticle 12.

The reticle stage assembly 18 holds and positions the reticle 12 relative to the optical assembly 24 and the wafer 14. Similarly, the wafer stage assembly 20 holds and positions the wafer 14 with respect to the projected image of the illuminated portion of the reticle 12. Each stage assembly 18, 20 can include one or more actuators or motors.

The optical assembly 24 collects and focuses the illumination beam 40 of radiation that is reflected from the reticle 12 to the wafer 14. Depending upon the design of the lithography system 10, the optical assembly 24 can magnify or reduce the size of the image at the wafer of the illuminated region of the reticle 12. Alternately, the optical assembly 24 could also be a 1x magnification system.

As provided above, the optical assembly 24 includes one or more optical elements 28, one or more element mounts 30, and the element control system 32. The number of optical elements 28 utilized and the design of each optical element 28 can be varied to suit the requirements of the optical assembly 28. In the embodiment illustrated in Figure 1, the optical assembly 24 is an all reflective system that includes four optical elements 28, namely a convex, first optical element 28A, a concave, second optical element 28B, a convex, third optical element 28C, and a concave, fourth optical element 28D. Further, each optical element 28 is a reflecting mirror. Alternatively, the optical assembly 24 can include more than four or less than four optical elements 28.

In Figure 1, each optical element 28 includes a front surface 38A and an opposed rear surface 38B. The front surface 38A defines a figure that is curved so that the light rays that strike the front surface 38A converge or diverge. Each optical element 28 includes an element body that is coated with multiple thin layers of material that collectively create a fairly reflective surface at the wavelength of the illumination beam 40. The element body can be made of a glass or ceramic material having a relatively low coefficient of thermal expansion. The type of material utilized for the layers of reflective material will depend upon the wavelength of the radiation generated by the illumination source 34. For example, suitable layers include molybdenum/silicon for wavelengths of approximately 13 nm and molybdenum/beryllium for wavelengths of approximately 11 nm. However, other materials may be utilized.

At the short wavelengths of EUV radiation, materials are currently not available for the reflective thin layers which will provide very high reflectivities typical of optical reflective coatings at visible and near visible wavelengths. Achievable reflectivities may not exceed much more than $r = 0.65$, as compared to greater than 0.99 at longer wavelengths. As a result, significant amounts of optical power are absorbed in the surfaces of the optical elements 28. For a mirror reflectivity of r, a fraction r of the optical power incident on the optical element 28 is reflected, and a fraction (1-r) is absorbed. For the case of an optical assembly 24 that includes four optical element 28, as illustrated in Figure 1, if the optical power emerging from the reticle 12 and collected by the optical element 28 is $P_R$, and the optical power incident on the wafer 14 is $P_W$, then it follows that $P_W = F^4 P_R$ (assuming the reflectivities of the optical elements 28 to be the same, and no apertures between the optical elements 28A - 28D intercept part of the illumination beam 40). Furthermore, the power absorbed in optical elements 28A - 28D is given by the expressions:

$$P_{28A} = (1-r)P_R$$

$$P_{28B} = r(1-r)P_R$$

$$P_{28c} = r^2(1-r)P_R$$

$$P_{28D} = r^3(1-r)P_R.$$

For example, if the power incident on the wafer 14 is 0.1 W, the power emerging from the reticle 12 and collected by the optical element 28 must be equal to $0.1/(0.65)^4 = 0.56$ W, and the power absorbed in the mirrors is then $P_{2BA} = 0.196$ W, $P_{28B} = 0.127$ W, $P_{28c} = 0.083$ W, and $P_{28D} = 0.054$ W. Thus significant amounts of power may be absorbed by the optical elements 28, with the largest amounts being in the optical elements 28 closest to the reticle.

Each optical element 28 can include one or more circulating channels (not shown) that extend through the element body for cooling the optical elements 28. The circulating channels can be positioned in the element body so that a circulating fluid can be circulated relatively evenly throughout the optical element 28.

In Figure 1, the illumination system 16 directs illumination beam 40A at the reticle 12. An illumination beam 40B is reflected off the reticle 12. An illumination beam 40C is reflected off the first optical element 28A. An illumination beam 40D is reflected off the second optical element 28B. An illumination beam 40E is reflected off the third optical element 28C. An illumination beam 40F is reflected off the fourth optical element 28D.

It should be noted that for each optical element 28, the illumination beam 40 may not be directed to the entire front surface 38A. For example, during an exposure procedure, the illumination beam 40C is reflected off only the bottom portion of the second optical element 28B. At this time, the second optical element 28B includes an illuminated region 42 that reflects the illumination beam 40C and a non-illuminated region 44. As used herein, the term "illuminated region" 42 shall mean and represent the area on the front surface 38A that is illuminated by and collects light from the illumination beam 40C, Further, the term "non-illuminated region" 44 shall mean and represent the area on the front surface 38A that does not collect and is not illuminated by the illumination beam 40C.

The size and location of the illuminated region 42 can vary with time according to the illumination beam 40B that is being reflected off the reticle 12. Stated another way, the total radiation incident on the optical element 28 will vary with the average reflectance of the illuminated reticle 12. In addition, the illuminated region 42 can be somewhat arc shaped, annular shaped, or semicircular shaped. As provided herein, one or more of the first optical element 28A, the third optical element 28C and/or the fourth optical element 28D can also include an illuminated region and a non-illuminated region.

Since the illuminated region 42 may represent only a fraction of the surface of the optical element 28, and since significant amounts of power may be absorbed by the optical element 28, non-uniform heating of the surface of the optical element 28 will occur, resulting typically in a non-uniform temperature distribution, and thermal distortions which are non-uniform. Typically the non-uniformities will be largest near the boundary between the illuminated region 42 and non-illuminated region 44 of the optical element 28. Moreover, the illuminated region 42 may not be illuminated uniformly by the illumination radiation, because of the optical design, thereby further exacerbating the situation.

The optical mounts 30 retain the optical elements 28. The optical mounts 30 can hold the optical elements 28 in a quasi-kinematic mode, such as described in U.S. Patent No. 6,239,924. As far as is permitted, the contents of U.S. Patent N0. 6,239,924 are incorporated herein by reference. As provided herein, the optical mounts 30 can be used in conjunction with the element control system 32 to reduce optical aberrations. More specifically, the element control system 32 can be used to simplify the form of the thermal distortion of the optical element 28. If residual distortions in the optical element 28 are of a relatively simple form, it may be possible to adjust the position and orientation of the optical elements 28 with the element mounts 30 to cancel out the thermal distortion produced by the illumination beam 40.

The element control system 32 can provide a controlled and constant temperature distribution, reducing the complexity of thermal distortions and thereby reduce, alter, or simplify optical aberrations in one or more of the optical elements 28. For example, in Figure 1, the element control system 32 can be used to reduce thermal distortions in the first optical element 28A, the second optical element 28B, the third optical element 28C, and/or the fourth optical element 28D. Alternately, the element control system 32 could be used to reduce thermal distortions in more than four or less than four optical elements 28. For example, the third or the fourth optical elements 28C and 28D may not require correction of thermal deformations, because the optical power absorbed by them is relatively small.

In Figure 1, the element control system 32 includes a circulating system 46 (illustrated as a box), and a thermal adjuster 48. The circulating system 46 directs a circulation fluid 49 through circulating channels in one or more of the optical elements 28 to cool one or more of the optical elements 28. The design of the circulating system 46 can be varied to suit the cooling requirements of the optical elements 28. For example, the circulating system 46 can direct the circulation fluid 49 to each of the optical elements 28 and can include a reservoir for receiving the circulation fluid 49, a heat exchanger, i.e. a chiller unit, for cooling the circulation fluid 49, and a fluid pump. The temperature, flow rate, and type of the circulation fluid 49 are selected and adjusted to precisely control the temperature of the one or more of the optical elements 28. Alternatively, a heat pipe could be used.

The thermal adjuster 48 selectively heats portions of one or more of the optical elements 28. In one embodiment, as illustrated in Figure 1, the thermal adjuster 48 heats the front surface 38A of one or more of the optical elements 28. As an example, the thermal adjuster 48 can provide a controlled and constant temperature distribution in a portion of one or more of the optical elements 28.

In Figure 1, the thermal adjuster 48 may include a heat source 50 for each optical element 28. Additional heat sources 50 can be used so that the temperature distribution in the optical elements 28 near the front surface 38A can be fine tuned. In this embodiment, each heat source 50 projects a beam of radiation 52 at one of the optical elements 28, a portion of which is absorbed by the optical element 28. The radiation 52 selectively heats portions of one of the optical elements 28. The area of the optical element 28 directly heated by the radiation 52 is referred to herein as the heated region 54. For example, the radiation 52 can be used to heat a portion or all of the non-illuminated region 44, and/or the radiation 52 can be used to heat a portion or all of the illuminated region 42.

The shape and intensity of the radiation 52 can be varied. For example, the heat source 50 could be pulsed at the same rate as the illumination source 34, to maintain instantaneous temperature uniformity. Alternatively, the heat source 50 output could be constant, and an auxiliary heat source could be directed at the illuminated region 42 and pulsed on at times between the pulses of the illumination source 34. Thus, the temperature distribution on the optical element 28 would have no time dependent component, once the optical element 28 had reached its temperature equilibrium after turn on. In addition, the auxiliary heat source could be directed at the illuminated region 42 and turned on at times when the illumination source 34 is turned off, for example when a wafer 14 or reticle 12 is being exchanged.

As provided herein, the intensity from the heat source 50 can be adjusted so that the temperature in the heated region 54 is approximately equal to the temperature in the illuminated region 42. Alternatively, the heat source 50 can be controlled so that the temperature in the heated region 54 is greater than or less than the temperature in the illuminated region 42.

Examples of suitable heat sources 50 include light from a mercury arc lamp or other incandescent light source, possibly including a filter to eliminate spectral components of the radiation that could expose the photoresist, or a laser. In one embodiment, the spectrum, of the radiation 52 from the heat source 50 does not include spectral components that could expose the photoresist on the wafer 14, should scattered light reach the wafer 14. For example, heat source 50 can be a laser or an incoherent source of much longer wavelength than 15 nm. For example, the heat source 50 could generate radiation 52 having a radiation wavelength that is greater than approximately 100 nm, 125 nm, 150 nm, 175 nm, 200 nm, 250 nm, 300 nm, 350 nm, 400 nm, 450 nm, 500 nm, 600 nm, 700 nm, 800 nm, 900 nm, or 1000 nm. In one embodiment, the wavelength of the radiation is greater than the illumination wavelength of the illumination beam 40. For example, the radiation wavelength can be at least approximately 2, 3, 5, 10, 20, 30, 40, 50, 60, 70, 80, 90, 100 times greater than the illumination wavelength. Additionally, the radiation spectrum of the radiation 52 can be chosen such that absorbance in the optical element 28 is maximized.

The radiation 52 from the heat source 50 may be projected onto a predetermined area of the heated region 54, or it may be scanned over the area of the heated region 54.

Alternatively, the heat source 50 can be a surface in close proximity to and overlying the non-illuminated region 44, which surface is maintained at an elevated temperature. Radiant heat transfer between the source 50 and the non-illuminated region 44 will raise the temperature of the non-illuminated region 44. Proper adjustment of the temperature of the heat source 50 will allow adjustment of the temperature of the non-illuminated region 44 to the desired value. The radiation spectrum of the heat source 50 would then be a broad, approximately black body spectrum. At temperatures near room temperature, the spectrum would peak in the infrared at a wavelength of approximately 10 micron. The fraction of this spectrum which overlaps the range of wavelengths where the photosensitive resist is sensitive is negligible.

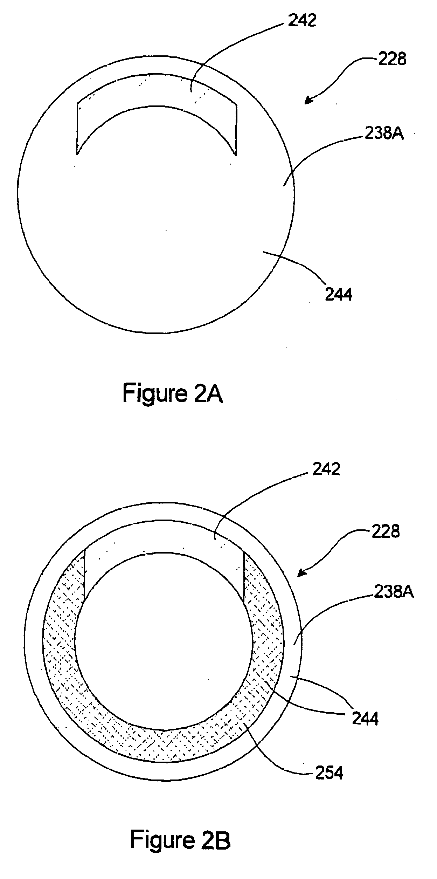

Figure 2A is a view of a front surface 238A of one optical element 228 that illustrates an example of an illuminated region 242 (in diagonal line shading) and an example of a non-illuminated region 244 (without shading). In this embodiment the optical element 228 possesses axial symmetry. The illuminated region 242 represents the shape of the area on the front surface 238A that is illuminated by 'the illumination beam 40 (illuminated in Figure 1) from the illumination system 16 (illustrated in Figure 1). The non-illuminated region 244 represents the area on the front surface 238A that is not illuminated by the illumination beam 40 from the illumination system 16.

Figure 2B is a view of the front surface 238A of the optical element 228 from Figure 2A with the heat source 50 (illustrated in Figure 1) heating a portion of the optical element 228. More specifically, Figure 2B illustrates the illuminated region 242 (in diagonal line shading), a heated region 254 (in cross-shading), and the non-illuminated region 244 (no shading and cross-shading). The heated region 254 represents the area on the front surface 238A that is heated by the radiation 52 (illustrated in Figure 1) from the heat source 50.

In this embodiment, the illuminated region 242 is somewhat arc shaped and the heated region 254 is also somewhat arc shaped. With this design, the illumination region 242 and the heated region 254 combine to form an annular shaped area of elevated temperature that is axially symmetric. Stated another way, Figure 2B illustrates that the temperature distribution in the illuminated region 242 is made axially symmetric by heating the heated region 254. Because the azimuthal temperature distribution is now substantially uniform, the azimuthal components of any thermal distortion in the illuminated region 242 should be eliminated, and therefore optical aberrations associated with azimuthal distortions should be eliminated as well. Thus, some higher order geometric aberrations might be reduced to a tolerable level, and some lower order aberrations dealt with by adjustment of the optical element 228 with the element mounts 30 (illustrated in Figure 1).

In one embodiment, the intensity of the radiation 52 from the heat source 50 is adjusted so that the absorbed intensity from the heat source 50 is approximately equal to the absorbed intensity from the illumination source 34. Stated another way, the heat source 50 is controlled so that the temperature in the heated region 254 is approximately equal to the temperature in the illuminated region 242. In this embodiment, the average intensity of the radiation from the illumination source 34 is relatively constant and the average intensity of the radiation 52 from the heat source 50 is relatively constant.

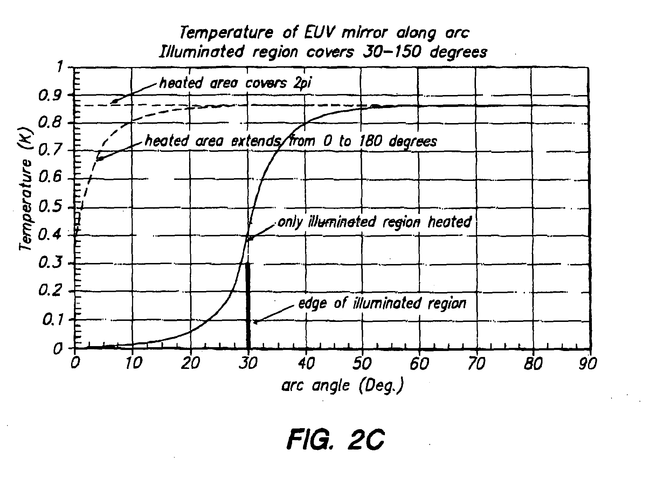

Figure 2C illustrates the application of this embodiment with some modeling results. The illuminated region 242 of the optical element 228 (illustrated in Figure 28) is exposed uniformly to an illumination source 34 (illustrated in Figure 1), and the temperature in the optical element 228 is calculated using the heat equation. The illuminated region 242 is an annular segment of 120 degrees extent. Half of the segment, extending between 30 and 90 degrees, is illustrates in Figure 2C. Despite the uniform illumination, Figure 2C illustrates that the temperature at the surface of the optical element 228 is far from uniform in the region near the azimuthal edge of the illuminated region 242, between the angles of 30 and approximately 50 degrees. Within this region, local distortion may be expected to be non-uniform, leading to the presence of higher order aberrations with an azimuthal dependence. Additional heating from heat sources 50, adjusted to provide the same absorbed power density as the illumination source 34, eliminates this temperature variation and should substantially reduce or eliminate the distortion non-uniformity. A heated region 254 covering an angular range of 30 degrees on each side of the illuminated region 242 is adequate to completely remove the temperature variations in the illuminated region 242. However, if the optical element 228 possesses axial symmetry, extending the heated region 254 to the full azimuthal range may simplify the non-local distortions, thereby reducing lower order aberrations and making mechanical adjustment of the optical element 228 easier.

In this embodiment, the heated region 254 is entirely part of the non-illuminated region 244. However, the heated region 254 can be part of the illuminated region 242, if necessary, to minimize thermal distortion. For example, in the embodiment shown in Figure 2A, the illuminated region 242 is assumed to be illuminated uniformly by the illumination beam 40. For that reason, the heated region 254 is contiguous with the azimuthal boundaries of the illuminated region 242, and it does not extend into the illuminated region 242. However, if the intensity of the illumination beam 40 varies within the illuminated region 242, the heated region 254 could be expanded to include the regions of the illuminated region 242 which are non-uniformly illuminated, so that the absorbed power density in the optical element 228 from the sum of the incident radiations is approximately uniform over the illuminated region 242.

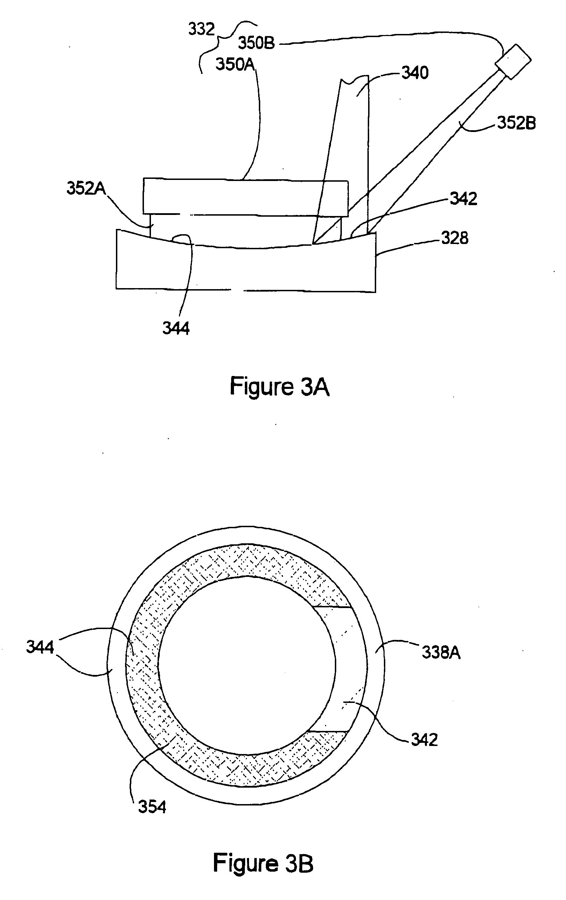

Figure 3A is a side view of an optical element 328, an illumination beam 340 and another embodiment of an element control system 332. In this embodiment, the element control system 332 includes a first heat source 350A and a second heat source 350B. This embodiment can be used if the intensity of the illumination beam 340 collected by the optical element 328 is spatially dependant. In Figure 3A, the first heat source 350A directs radiation 352A at a non-illuminated region 344 and the second heat source 350B directs radiation 352B at an illuminated region 342. Figure 3A also illustrates that the illumination beam 340 is directed at the illuminated region 342.

In this embodiment, the second heat source 350A is independent from the first heat source 350B. The second heat source 350B is time dependant and can be utilized for example if the average reflectance from the reticle varies as the illumination beam 340 scans over it, causing variations in the intensity of the illumination beam 40B. As an example, the first heat source 350A provides an absorbed constant intensity of Ib on the optical element 328, the illumination beam 340 provides a time dependant, average absorbed intensity I(t), and the second heat source 350B provides a time dependant, average absorbed intensity Ic(t). For this example, absorbed intensity from the heat sources 350A, 350B is adjusted to instantaneously satisfy the relation Ib = I(t) + Ic(t Consequently the temperature distribution in the illuminated region 342 should be relatively constant in time, and proper adjustment of the heat sources 350A and 350B can eliminate any azimuthal dependence in distortion within the illuminated region 342.

In this embodiment, the first and second heat sources 350A, 350B can be somewhat similar to the heat source 50 described above. Figure 3A illustrates that the first heat source 350A can be a proximity heater, which heats by radiant heat transfer, mounted above the optical element 328, while the second heat source 350B generates a beam of electromagnetic radiation and is focused on the illumination region 342 from a source off-axis, but other configurations are possible.

Figure 3B is a view of the front surface 338A of the optical element 328 that illustrates the illuminated region 342 (in diagonal line shading), the non-illuminated region 344 (no shading and cross-shading), and the heated region 354 (in cross-shading). Again the element 328 is axially symmetric. The heated region 354 represents the area that is heated by the radiation 352A (illustrated in Figure 3A). In this embodiment, the illuminated region 342 represents the area that is illuminated by the illumination beam 340 (illustrated in Figure 3A) and the radiation 352B (illustrated in Figure 3A). With this design. the irradiation pattern from the illumination beam 340 and the temperature distribution is made axially symmetric by irradiating the optical element 328 with radiation 352A, 352B. Therefore, distortions with an azimuthal dependence should be eliminated, and optical aberrations associated with azimuthal distortions should be eliminated as well. Thus, some higher order geometric aberrations might be reduced to a tolerable level, and some lower order aberrations dealt with by realignment of the optical element 228 with the element mounts 30 (illustrated in Figure 1).

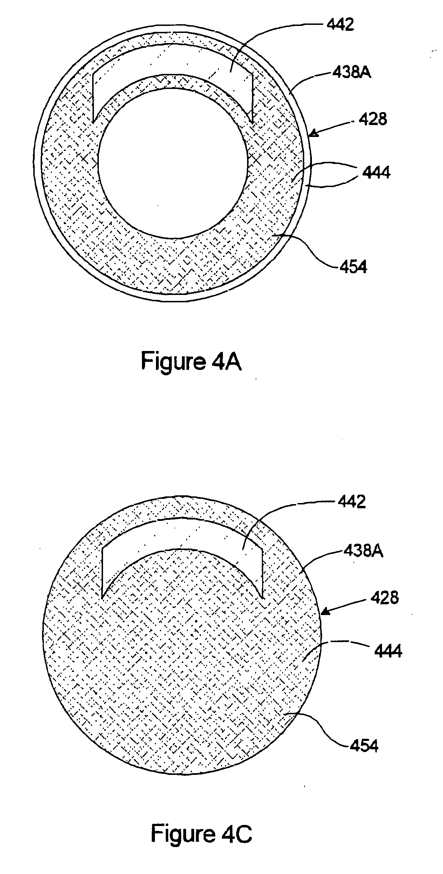

Figure 4A is a view of a front surface 438A of another embodiment of an axially symmetric optical element 428 that illustrates the illuminated region 442 (in diagonal line shading), the non-illuminated region 444 (without shading and cross-shading), and the heated region 454 (in cross-shading). In this embodiment, the illuminated region 442 is somewhat arc shaped and the heated region 454 is also somewhat annular shaped and includes an arc shaped opening. With this design, the heated region 454 provides axial symmetry, and the heated region 454 encircles and surrounds the illuminated region 442. As before, the axial symmetry of the temperature distribution should eliminate optical aberrations possessing an azimuthal dependence. Providing heated regions 454 at the inner and outer radii of the illuminated region 442 should reduce or eliminate the radial dependence of the thermal distortions within the illuminated region 442. This should reduce or eliminate a class of optical aberrations that would be associated with the radially dependent distortion.

In this embodiment, the illuminated region 442 is somewhat arc shaped and the non-illuminated region 444 is somewhat circular shaped without an arc shaped area that represents the illuminated region 442. However, the illuminated region 442 and the non-illuminated region 444 can have other shapes. For example, the illuminated region 442 can be a semicircular shape or a rectangular shape. However, in order to preserve any advantages of heating a total area which possesses azimuthal symmetry, the non-illuminated region 444 should be designed, so that the total illuminated and heated regions possess azimuthal symmetry.

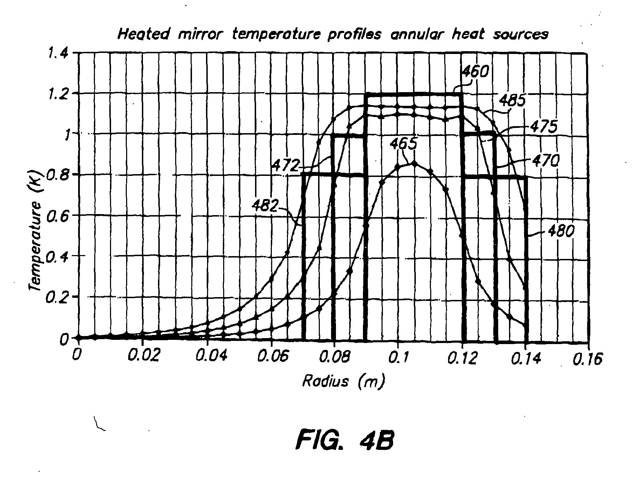

Figure 4B illustrates the application of heat sources to the radial edges of the illuminated region, in order to reduce radial temperature variations in the illuminated region. Again, the heat equation was used to explore the effects of adding heat sources. Although the illumination beam is assumed to have uniform intensity, the resulting temperature distribution 465 is significantly non-uniform within the illuminated region 460, which in this model lies within the radii 0.09 m and 0.12 m. The peak temperature within the illuminated region 460 is approximately 0.87 degree, and the variation is 0.35 degree. By adding uniform heat sources 470 and 472 of radial extent 0.01 m and adjacent to the radial edges of the illuminated region 460, the variation of the temperature 475 within the illuminated region 460 can be reduced to 0.017 degree, an improvement of a factor of 20. In this case the absorbed intensity of the added heat sources 470, 472 is different from that of the illumination radiation: the absorbed intensity of heat source 470 is 50% higher and that of heat source 472 is 40% higher. The temperature uniformity can be improved further if desired. For example, heat source 480, lying between radii 0.12 m and 0.14 m and with absorbed intensity 15% higher than the illumination radiation, and heat source 482, lying between radii 0.07 m and 0.09 m and with absorbed intensity 20% higher than the illumination radiation, create a temperature distribution 485 with a variation of only 0.01 degree within the illuminated region 460.

Note that this improvement in temperature uniformity results in an increase in the temperature within the illuminated region 460 from 0.87 to over 1.1 degree. Therefore, the absolute value of the thermal distortion is actually increased. However, since the local shape of the distortion is expected to be of a uniform shape now, the optical aberrations associated with the distortion should be simplified and more easily correctable.

Figure 4C is a view of the front surface 438A of the optical element 428 that illustrates the illuminated region 442 (in diagonal line shading), the non-illuminated region 444 (in cross-shading), and the heated region 454 (in cross-shading). In this embodiment, the illuminated region 442 is somewhat arc shaped and the heated region 454 is somewhat circular shaped and includes an arc shaped opening. With this design, the heated region 454 provides axial symmetry, and the heated region 454 encircles and surrounds the illuminated region 442. As before, providing heated regions 454 at the inner and outer radii of the illuminated region 442 should reduce or eliminate the radial dependence of the thermal distortions within the illuminated region 442. This should reduce or eliminate a class of optical aberrations which would be associated with the radially dependent distortion.

It is believed that the heating schemes illustrated in Figures 4A and 4C will reduce the radial temperature distribution in the optical element 428, and reduce some higher order geometric aberrations. Adding a radial dependence to the heat sources may reduce the radial temperature distribution in the illuminated region 442 further.

With the addition of one or more heat sources, thermal distortion of the optical element 428 may be reduced in complexity such that higher order optical aberrations are reduced to a tolerable level and relatively simple mechanical distortion or realignment of the optical element can eliminate the remaining lower order aberrations. The deliberate mechanical distortion could be done either by means of the mechanical element mount or perhaps by the addition of more heat sources at other locations.

Figure 5A illustrates another embodiment of an optical element 528, a plurality of element mounts 530, an illumination beam 540, and another embodiment of an element control system 532. In this embodiment, the element control system 532 includes a first heat source 550A generating radiation 552A, a second heat source 550B generating radiation 552B and an element measurement system 560. The illumination beam 540, the first heat source 550A and the second heat source 550B are somewhat similar to the corresponding components described above and illustrated in Figure 3A.

The element measurement system 560 monitors the optical element 528 for thermal distortions. For example, the measurement system 560 could monitor the temperature of the optical element 528 at one or more spaced apart locations, and infer the resulting distortion from a model and/or previously calibrations, or monitor the shape of the optical element 528 directly at one or more locations. For example, the element measurement system 560 can monitor temperature or shape of the front surface 538A or the back surface 538B of the optical element 528. In Figure 5A, the element measurement system 560 monitors a portion of the front surface 538A of the optical element 528. The element measurement system 560 can utilize laser interferometers, or other optical or non-optical sensors to monitor the optical element shape, and/or it can use thermistors, bolometers, or other temperature sensing means to monitor the element temperature.

With the information from the element measurement system 560, the intensity and shape of the radiation 552A, 552B can be adjusted. Stated another way, the element control system 532 can make real time changes to the shape and intensity of the radiation 552A, 552B based upon the information from the element measurement system 560 to reduce andlor simplify distortion caused by the illumination beam 540.

Figure 5B is a view of the front surface 538A of the optical element 528 that illustrates the element mounts 530, the illuminated region 542 (in diagonal line shading), the non-illuminated region 544 (without shading and with cross-shading), and the heated region 554 (in triangular cross-shading) and the monitored area 562 (square cross-shading) that is monitored by the element measurement system. In this embodiment, the element measurement system includes a plurality of sensors positioned in the monitored area 562 that monitor a region of the front surface 538A, which is identical in shape to the illuminated region 542 and located relative to the attachment points of the element mounts 530 identically to that of the illuminated region 542. Further, the sensors are located in the non-illuminated region 544 and away from the illuminated region 542. Thus, the sensors will not adversely influence the illumination beam and will not interfere with normal lithography operation.

In this embodiment, the axial symmetry of the mirror and the temperature distribution can allow the sensors to be located away from the illuminated region 544 but at radial and azimuthal locations which are as environmentally comparable to the illuminated region 544 as possible. In this example, the optical element 528 is mounted at four symmetrical locations with four identical element mounts 530. Other mounting schemes are possible, such as a three point kinematic mounting scheme. The monitored area 562 of the optical measurement system is substantially identical in shape and radial location to the illumination region 542. In addition, its position relative to the element mounts 530 is the same as the illumination region 542. Therefore, identical adjustments to the element mounts 530 adjacent to the illumination region 542 and the monitored area 562 are likely to produce similar changes to the two surface areas. After initial calibration, changes to the surface in the monitored area 562 may track the changes in the illumination region 542 to within tolerable accuracy.

Alternatively, the sensors could be positioned to monitor the illuminated region 542 directly, provided they do not interfere with the illumination beam 40 incident on the optical elements 528.

In some optical designs, one or more of the optical elements may not possess axial symmetry, either to reduce the size of the optics or to permit passage of a reflected illumination beam in a folded optical configuration. For example, Figure 6A illustrates a view of a front surface 638A of an optical element 628 that illustrates an illuminated region 642 (in diagonal line shading), a non-illuminated region 644 (in cross-shading), and a heated region 654 (in cross-shading). In this embodiment, the optical element 628 is truncated to a sector, the illuminated region 642 is arc shaped and the heated region 654 encompasses the rest of the front surface 638A.

Further, Figure 6B illustrates a view of the front surface 638A of the optical element 628 that illustrates the illuminated region 642 (in diagonal line shading), the non-illuminated region 644 (in cross-shading), and the heated region 654 (no shading and in cross-shading). In this embodiment, the optical element 642 is a sector of an annulus, the illuminated region 642 is arc shaped and the heated region 654 encompasses the rest of the front surface 638A.

In these cases, axial symmetry of the optical element and the heat from the heat source (not shown) plus the illumination beam 40 cannot be invoked to ensure the elimination of azimuthal thermal distortion within the illuminated region 642. However, it is still possible to apply additional heat from the heat source to the non-illuminated region 644 around the illuminated region 642 and within the illumination region 642 as described above, so that the temperature distribution within the illumination region 642 is uniform, and any residual thermal distortions in the illuminated region 642 of the optical element 628 are constant in time and of relatively simple form. Choosing the appropriate additional heat sources is more complicated now and is likely to require finite element modeling and calibration with real optical elements 628.

Figure 7 illustrates a view of a front surface 738A of an optical element 728 including an illuminated region 742 (in diagonal shading) and a non-illuminated region 744 (in cross-shading). In this embodiment, the entire non-illuminated region 744 is coated with an absorbing layer 770. Alternatively, only a portion of the non-illuminated region 744 is coated with the absorbing layer 770.

The absorbing layer 770 enhances the absorption of radiation from the heat source (not shown). For example, the non-illuminated region 744 could be coated with a black layer that absorbs more radiation than the illuminated region 742. As a result thereof, the intensity of the radiation from the heat source can be reduced while still maintaining a uniform temperature.

While the method and system as shown and disclosed herein is fully capable of obtaining the objects and providing the advantages herein before stated, it is to be understood that it is merely illustrative of the presently preferred embodiments of the invention and that no limitations are intended to the details of construction or design herein shown other than as described in the appended claims.

## Claims

1. An element control system that reduces thermal distortions in an optical element, the optical element including an illuminated region and a non-illuminated region, the element control system comprising:

   a heat source that primarily heats at least a portion of the non-illuminated region of the optical element.

2. The element control system of claim 1 wherein the heat source heats a portion of the optical element to control the shape of the optical element.

3. The element control system of claim 1 wherein the heat source transfers heat to at least a portion of the non-illuminated region of the optical element.

4. The element control system of claim 1 wherein the heat source transfers heat to substantially the entire non-illuminated region.

5. The element control system of claim 1 wherein the heat source transfers heat to a region that substantially surrounds the illuminated region.

6. The element control system of claim 1 wherein the heat source heats at least a portion of the non-illuminated region of the optical element so that a temperature of at least a portion of the non-illuminated region is approximately equal to a temperature of the illuminated region.

7. The element control system of claim 1 further comprising a second heat source that heats at least a portion of the illuminated region of the optical element.

8. The element control system of claim 1 wherein the heater source is controlled so that the temperature within the illuminated region is uniform.

9. The element control system of claim 1 further comprising a circulating system that circulates a fluid through the optical element.

10. The element control system of claim 1 wherein the intensity of heat from the heat source can be varied.

11. The element control system of claim 1 further comprising an element measurement system that takes measurements of the optical element.

12. The element control system of claim 11 wherein the amount of heat transferred from the heat source to the optical element is varied according to the measurements taken by the element measurement system.

13. The element control system of claim 1 wherein the heat source heats the non-illuminated region to provide axial temperature symmetry to the optical element.

14. An optical assembly comprising the element control system of claim 1 and an optical element having an illuminated region and a non-illuminated region.

15. The optical assembly of claim 14 wherein at least a portion of the non-illuminated region of the optical assembly includes an absorbing layer that enhances the absorption of light.

16. An exposure apparatus for transferring an image from a reticle to a wafer, the exposure apparatus comprising the optical assembly of claim 14 and an illumination system that generates an illumination beam.

17. The exposure apparatus of claim 16 wherein the heat source directs radiation at the optical element, the radiation having a wavelength that is different than a wavelength of the illumination beam.

18. The exposure apparatus of claim 16 wherein the heat source directs radiation at the optical element, the radiation having a wavelength that is greater than a wavelength of the illumination beam.

19. The exposure apparatus of claim 16 wherein the heat source directs radiation at the optical element, the radiation having a wavelength that is at least approximately two times greater than a wavelength of the illumination beam.

**20.** The exposure apparatus of claim 16 wherein the heat source directs radiation at the optical element, the radiation having a wavelength that is at least approximately five times greater than a wavelength of the illumination beam.

**21.** The exposure apparatus of claim 16 further comprising a heat source that directs radiation at the optical element, the radiation having a wavelength that does not influence a photoresist on the wafer.

**22.** The exposure apparatus of claim 16 further comprising of a control system that controls the heat source so that the temperature within at least the illuminated region is uniform.

**23.** A device manufactured with the apparatus according to claim 16.

**24.** A wafer on which an image has been formed by the apparatus of claim 16.

**25.** An exposure apparatus for transferring an image from a reticle to a wafer, the exposure apparatus comprising:

an illumination system that directs an illumination beam at the reticle; and
an element assembly including an optical element that collects light from the reticle and a heat source that heats the optical element.

**26.** The exposure apparatus of claim 25 wherein the heat source directs radiation at the optical element, the radiation having a wavelength that is different than an illumination wavelength of the illumination beam.

**27.** The exposure apparatus of claim 26 wherein the wavelength of the radiation that is greater than the illumination wavelength.

**28.** The exposure apparatus of claim 27 wherein the wavelength of the radiation is at least approximately two times greater than the illumination wavelength.

**29.** The exposure apparatus of claim 27 wherein the wavelength of the radiation is at least approximately five times greater than the illumination wavelength.

**30.** The exposure apparatus of claim 26 wherein the wavelength of the radiation does not influence a photoresist of the wafer.

**31.** The exposure apparatus of claim 25 wherein the optical element includes an illuminated region and a non-illuminated region and the heat source primarily heats at least a portion of the non-illuminated region of the optical element.

**32.** The exposure apparatus of claim 31 wherein the heat source heats a portion of the optical element to control the shape of the optical element.

**33.** The exposure apparatus of claim 31 wherein the heat source directs radiation at least a portion of the non-illuminated region of the optical element.

**34.** The exposure apparatus of claim 31 wherein the heat source directs radiation at substantially the entire non-illuminated region.

**35.** The exposure apparatus of claim 31 wherein the heat source directs radiation at an area that substantially surrounds the illuminated region.

**36.** The exposure apparatus of claim 31 wherein the heat source heats at least a portion of the non-illuminated region of the optical element so that a temperature of at least a portion of the non-illuminated region is approximately equal to a temperature of the illuminated region.

**37.** The exposure apparatus of claim 31 further comprising a second heat source that heats at least a portion of the illuminated region of the optical element.

**38.** The exposure apparatus of claim 25 further comprising a circulating system that circulates a fluid through the optical element.

**39.** The exposure apparatus of claim 25 wherein the intensity of heat from the heat source can be varied.

**40.** The exposure apparatus of claim 25 further comprising an element measurement system that takes measurements of the optical element.

**41.** The exposure apparatus of claim 40 wherein the amount of heat transferred from the heat source to the optical element is varied according to the measurements taken by the element measurement system.

**42.** The exposure apparatus of claim 25 wherein at least a portion of the optical element includes an absorbing layer that enhances the absorption of light.

**43.** A device manufactured with the apparatus according to claim 25.

**44.** A wafer on which an image has been formed by the apparatus of claim 25.

45. An optical assembly for an exposure apparatus, the optical assembly comprising:

an optical element including an illuminated region and a non-illuminated region, at least one of the regions being partly coated with an absorbing layer that enhances the absorption of radiation.

46. The optical assembly of claim 45 further comprising a heat source that heats a portion of the optical element to control the shape of the optical element.

47. The optical assembly of claim 46 wherein the heat source directs radiation at a non-illuminated region of the optical element.

48. The optical assembly of claim 47 wherein the heat source directs radiation at substantially the entire non-illuminated region.

49. The optical assembly of claim 46 wherein the heat source directs radiation at an area that substantially surrounds an illuminated region of the optical element.

50. The optical assembly of claim 46 wherein the heat source heats at least a portion of a non-illuminated region of the optical element so that a temperature of at least a portion of the non-illuminated region is approximately equal to a temperature of a illuminated region of the optical element.

51. The optical assembly of claim 46 wherein the heater source is controlled so that the temperature within the illuminated region is uniform.

52. The optical assembly of claim 46 further comprising a second heat source that heats at least a portion of an illuminated region of the optical element.

53. The optical assembly of claim 46 further comprising a circulating system that circulates a fluid through the optical element.

54. The optical assembly of claim 46 wherein the intensity of heat from the heat source can be varied.

55. The optical assembly of claim 46 further comprising an element measurement system that takes measurements of the optical element.

56. The optical assembly of claim 55 wherein the amount of heat transferred from the heat source to the optical element is varied according to the measurements taken by the element measurement system.

57. , An exposure apparatus for transferring an image from a reticle to a wafer, the exposure apparatus comprising the optical assembly of claim 46 and an illumination system that generates an illumination beam.

58. The exposure apparatus of claim 57 wherein the heat source directs radiation at the optical element the radiation having a wavelength that is different than a wavelength of the illumination beam.

59. The exposure apparatus of claim 57 wherein the heat source directs radiation at the optical element, the radiation having a wavelength that is greater than a wavelength of the illumination beam.

60. The exposure apparatus of claim 57 wherein the heat source directs radiation at the optical element, the radiation having a wavelength that is at least approximately two times greater than a wavelength of the illumination beam.

61. The exposure apparatus of claim 57 wherein the heat source directs radiation at the optical element, the radiation having a wavelength that is at least approximately five times greater than a wavelength of the illumination beam.

62. The exposure apparatus of claim 57 wherein the heat source directs radiation at the optical element, the radiation having a wavelength that does not expose a photoresist on the wafer.

63. A device manufactured with the exposure apparatus according to claim 57.

64. A wafer on which an image has been formed by the apparatus of claim 57.

65. A method for controlling thermal distortion in an optical element, the optical element including an illuminated region and a non-illuminated region, the method comprising the step of:

heating at least a portion of the non-illuminated region of the optical element with a heat source.

66. The method of claim 65 wherein the step of heating includes the step of directing radiation at the non-illuminated region of the optical element.

67. The method of claim 65 wherein the step of heating includes the step of directing radiation at substantially the entire non-illuminated region.

68. The method of claim 65 wherein the step of heating includes the step of directing radiation to an area that substantially surrounds the illuminated region.

69. The method of claim 65 wherein the step of heating includes the step of directing radiation at the non-illuminated region of the optical element so that a temperature of at least a portion of the non-illuminated region is approximately equal to a temperature of the illuminated region.

70. The method of claim 65 further comprising the step of heating the illuminated region of the optical element with a second heat source.

71. The method of claim 65 further comprising the step of circulating a fluid through the optical element.

72. The method of claim 65 further comprising the step of taking measurements of the optical element, and the step of heating includes the step of adjusting the amount of heat transferred from the heat source to the optical element according to the measurements taken.

73. The method of claim 65 wherein the step of heating includes the step of directing radiation to provide axial thermal symmetry of the optical element.

74. A method for making an exposure apparatus for transferring an image from a reticle to a wafer, the method comprising the steps of:

    providing an illumination system that directs an illumination beam at the reticle;
    providing an optical element that collects light from the reticle; and
    heating the optical element with a heat source.

75. The method of claim 74 wherein the step of heating the optical element includes the step of transferring radiation to the optical element, the radiation having a wavelength that is different than an illumination wavelength of the illumination beam.

76. The method of claim 75 wherein the wavelength of the radiation does not expose a photoresist on the wafer.

77. The method of claim 74 wherein the step of heating the optical element includes the step of directing radiation at the optical element, the radiation having a wavelength that is greater than an illumination wavelength of the illumination beam.

78. The method of claim 74 wherein the step of heating the optical element includes the step of directing radiation at the optical element, the radiation having a wavelength that is at least approximately two times greater than an illumination wavelength of the illumination beam.

79. The method of claim 74 wherein the step of heating the optical element includes the step of directing radiation at the optical element, the radiation having a wavelength that is at least approximately five times greater than an illumination wavelength of the illumination beam.

80. The method of claim 74 wherein the step of heating the optical element includes the step of controlling the shape of the optical element with the heat source.

81. The method of claim 74 wherein the optical element includes an illuminated region and a non-illuminated region and the step of heating the optical element includes the step of heating the non-illuminated region of the optical element.

82. The method of claim 81 wherein the step of heating the optical element includes the step of directing radiation to at least a portion of the non-illuminated region of the optical element

83. The method of claim 81 wherein the step of heating the optical element includes the step of directing radiation at substantially the entire non-illuminated area.

84. The method of claim 81 wherein the step of heating the optical element includes the step of directing radiation to an area that substantially surrounds the illuminated region.

85. The method of claim 81 wherein the step of heating the optical element includes the step of directing radiation at the non-illuminated region of the optical element so that a temperature of at least a portion of the non-illuminated region is approximately equal to a temperature of the illuminated region.

86. The method of claim 81 further comprising the step of heating at least a portion of the illuminated region with a second heat source.

87. The method of claim 74 further comprising the step of circulating a fluid through the optical element.

88. The method of claim 74 further comprising the step of taking measurements of the optical element and the step of heating includes the step of adjusting the amount of heat directed from the heat source to the optical element according to the measurements taken.

89. The method of claim 74 further comprising the step of coating at least a portion of the non-illuminated region of the optical element with an absorbing layer that enhances the absorption of radiation from the heat source.

**90.** A method for making an object including at least the photolithography process, wherein the photolithography process utilizes the apparatus made by the method of claim 74.

**91.** A method of making a wafer utilizing the apparatus made by the method of claim 74.

Figure 1

EP 1 376 092 A2

Figure 2A

Figure 2B

FIG. 2C

Figure 3A

Figure 3B

Figure 4A

Figure 4C

Heated mirror temperature profiles annular heat sources

FIG. 4B

Figure 5A

Figure 5B

Figure 6A

Figure 6B

Figure 7